(19) Europäisches Patentamt
European Patent Office
Office européen des brevets

(11) Publication number: 0 072 321 B1

(12) **EUROPEAN PATENT SPECIFICATION**

(45) Date of publication of patent specification: **16.04.86**

(51) Int. Cl.$^4$: **G 03 F 7/08**, G 03 F 7/10

(21) Application number: **82401476.5**

(22) Date of filing: **05.08.82**

(54) **Positive-working resist compositions having improved development rates.**

(30) Priority: **06.08.81 US 290461**

(43) Date of publication of application:
**16.02.83 Bulletin 83/07**

(45) Publication of the grant of the patent:
**16.04.86 Bulletin 86/16**

(84) Designated Contracting States:
**DE FR GB**

(56) References cited:
**US-A-3 661 582**
**US-A-4 108 664**

**RESEARCH DISCLOSURE, no. 219, July 1982, pages 245-6, no. 21906, Havant-Hampshire (GB), "Positive-working resist composition and imaging method having improved development rates"**

(73) Proprietor: **EASTMAN KODAK COMPANY**
**343 State Street**
**Rochester New York 14650 (US)**

(72) Inventor: **Daly, Robert Curtis**
**617 Meadowbriar Road**
**Rochester New York 14616 (US)**
Inventor: **Guild, John Raymond**
**232 Old Meadow Drive**
**Rochester New York 14626 (US)**

(74) Representative: **Parent, Yves et al**
**Kodak-Pathé Département Brevets et Licences**
**Centre de Recherches et de Technologie Zone Industrielle**
**F-71102 Chalon-sur-Saone Cédex (FR)**

**EP 0 072 321 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to positive-working resist compositions containing photographic speed-enhancing agents which agents are also modified to increase the development rates of the compositions.

Resist compositions are facing new challenges in the field of microelectronic fabrication. The need to mass-produce electronic devices containing microscopically dimensioned, etched configurations has resulted in demands for resist compositions with greater photographic speed, higher temperature resistance, and more rapid developability in order to reduce costs. ("Photographic Speed" as used herein refers to the sensitivity of the composition to activating radiation, and is not to be confused with the rapidity of development.)

U.S. Patent No, 3,661,582 describes agents which increase the photographic speed of positive-working resist compositions for exposure with an electron beam, which compositions contains 1,2-quinone diazide ester groups. These agents comprise heterocyclic compounds, the nuclear atoms of which consist of carbon atoms and from 2 to 4 nitrogen atoms at least one of which is bonded to hydrogen. 5-Chloro-benzotriazole and 1H-benzotriazole are included in the compounds described.

The long development time required to remove unexposed portions of the resist composition is one of the chief problems encountered in the use of positive-working resist compositions in the manufacture of microcircuits. The problem is multiplied, or course, if a plurality of exposure and development steps are required in the manufacture.

The problem is solved by providing a positive-working resist composition containing a 1,2-quinone diazide ester and a heterocyclic sensitivity-enhancing agent as described in U.S. Patent No. 3,661,582 which is modified to contain at least two halogen substituents appended from nuclear carbon atoms thereof.

Specifically, the present invention provides a positive-working resist composition containing a 1,2-quinone diazide condensation product and a sensitivity-enhancing agent which is a heterocyclic compound having one, two or three rings, the nuclear atoms of which consist of carbon atoms and from 2 to 4 nitrogen atoms, at least one of the nuclear nitrogen atoms being bonded to hydrogen characterized in that said compound has at least two halogen substituents appended from nuclear carbon atoms.

The art-recognized class of sensitivity-enhancing agents useful with 1,2-quinone diazide condensation products comprises heterocyclic compounds having one, two or three rings, the nuclear atoms of which consist of carbon atoms and from 2 to 4 nitrogen atoms wherein at least one of the nitrogen atoms is bonded to hydrogen. The bonding of at least one of the nitrogen atoms to hydrogen appears to be important to the instant invention, as analogous compounds lacking such a hydrogen substituent, such as polyhalogenated quinoxaline, do not provide the advantages of the invention.

The heterocyclic sensitivity-enhancing agents of the aforementioned U.S. Patent No. 3,661,582 unexpectedly produce improved development rates in positive-working resists incorporating quinone diazide esters, if they are polyhalogenated as described above.

The polyhalogenation of the members of this class of agents serves to unexpectedly provide improved rates of development compared to the same agent lacking the polyhalogenation. As used herein, "polyhalogenation" refers to the substitution of halogens so that at least two halogens are appended from nuclear carbon atoms. Preferably, each halogen is appended from a different nuclear carbon atom. "The rate of development" refers to the length of time needed to completely remove the areas that were imagewise exposed.

Specific polyhalogenated sensitivity-enhancing agents useful in the invention include polyhalogenated benzotriazole; 1,2-naphthotriazole; indazole; and 1,3,4-imidazopyridine.

The type of halogen used to polyhalogenate the heterocycle is not believed to be critical. Thus, polychloro-, polybromo-, polychlorobromo- and polyiodo-substituted heterocycles are believed to be useful. Optionally the polyhalogenated sensitivity-enhancing agent may include a mixture of polyhalogenated compounds.

A particularly useful polyhalogenated sensitivity-enhancing agent inludes a polyhalogenated benzotriazole having the formula:

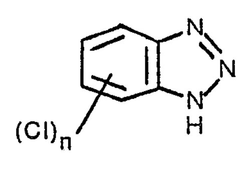

wherein n is 2, 3 and 4; or mixtures thereof. The compound which is selected depends in part on the preferred mode of synthesis. For example, the pure di- or the pure tetrachlorinated compound may be prepared by conventional techniques, such as by the reactions described in A. Krentzberger et al, *Arch. Pharm.,* Vol. 312, pp. 806—811 and Wiley et al, *J. Am. Chem. Soc.,* Vol. 77, p. 5105 (1955). On the other hand, mixed polyhalogenated compounds may be prepared by controlling the concentrations in a mixture of the non-halogenated heterocyclic compound with aqua regia. As the relative concentration of the non-halogenated heterocyclic compound of this mixture decreases, the number of halogen substituents on the heterocyclic compound increases.

To form a mixed halogenated heterocyclic compound, the starting material for the aqua regia reaction is, for example, a brominated heterocyclic compound.

The following preparations are illustrative of the syntheses that are available to append a plurality of halogen atoms to the nuclear carbon atoms of the sensitivity-enhancing agent:

Preparation No. 1

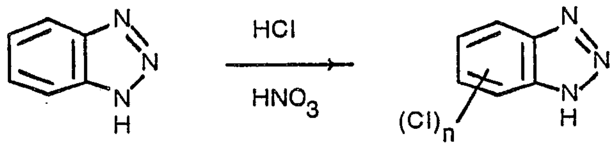


1,H-Benzotriazole (119 g, 1 mole) was added to an aqua regia solution containing 1,75 L of concentrated nitric acid and 5.15 L of concentrated hydrochloric acid. The resulting red solution was brought to reflux with mechanical stirring. After 30 minutes, a strong evolution of brown fumes commenced. After about 90 minutes of heating, a precipitate began to form. At 3 hours after the reaction started, the entire reaction mixture was a slurry.

The reaction mixture was allowed to cool to room temperture overnight. The precipitate was collected on a filter and washed with water. The wet precipitate was placed on a beaker and slurried with 2 L of water. The collected material was air dried for 2 hours on the filter funnel and dried at 65°C in a vacuum oven into which dry nitrogen gas was passed for 24 hours. A white, crystalline solid (172 g, m.p. 220—226°C) was obtained with a chlorine content of 49% by elemental analysis. This corresponds to a product mixture having an average substituent ratio of 3.2 chlorine and 0.8 hydrogen atoms.

Preparation No. 1′

The product mixture of Preparation No. 1 was further refined with respect to the extent of polyhalogenation, by recrystallization from an ethanol solution to obtain three fractions: a most insoluble (fraction I), a most soluble (fraction S), and an intermediate fraction (fraction M). The results were as follows:

| Fraction | Average n for $(Cl)_n$ | m.p. (°C) |
|---|---|---|
| I | 3.95 | 260—265 |
| M | 3.35 | 230—236 |
| S | 2.78 | 215—219 |

Preparation No. 2

When the procedure of Preparation No. 1 was repeated except that the concentration of benzotriazole was doubled. The average value of n for the mixture decreased to 3.05.

Any of the products resulting from Preparation No. 1, 1′, and 2 is useful in the invention.

Any positive-working resist containing a light-sensitive quinone-diazide condensation product is useful with the sensitivity-enhancing agents of the invention. For example, a phenol-formaldehyde resin, a cresolformaldehyde resin or an aminostyrene copolymer condensed with the esterifying agent.

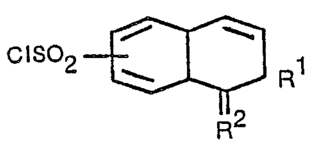

wherein one of $R^1$ and $R^2$ is $N_2$ and the other is O, are highly useful. Examples of these quinone diazide condensation products are well known in the literature, for example, U.S. Patent No. 4,141,733, and British Specification No. 1,546,633.

In addition to the above esters, which are primarily polymers, other compounds, such as monomers or binders are optionally included in the resist composition. Useful examples of such monomers include quinone diazide sulfonic acid esters such as the esters listed in Kosar, *Light-Sensitive Systems,* 1965, pp. 343—352, and particularly those prepared from dihydroxy- and trihydroxybenzene, for example, 1,2-naphthoquinone diazide sulfonic acid esterified with 1,3,5-trihydroxybenzene, as described in U.S. Patent No. 3,130,047; and quinone diazide sulfonic acid esters of trihydroxybenzophenone.

Useful examples of binders include vinyl-addition polymers such as acrylates or methacrylates copolymerized with acrylic or methacrylic acid and other vinyl-addition polymers examples of which are set forth in the aforesaid U.S. Patent No. 4,141,733.

The amounts of the components of the resist composition vary, depending upon the use and exposure source intended. Preferably, the monomer, if any, comprises from 0.5 to 25 weight % of the dry solids of the resist composition, and the quinone diazide condensation product from 1.0 to 15 weight %. The sensitivity-enhancing agent is present in an amount effective to increase for a predetermined exposure level the development rate of the composition compared to the same composition wherein the agent has less than two halogen substituents. For this purpose preferably the agent comprises from 5 to 30 weight % of the dry solids weight of the resist, and most preferably 15 weight %. The most preferred polyhalogenated sensitivity-enhancing agent is a mixture of di-, tri-, and tetrahalogenated compounds since such a mixture is more soluble than any one of the pure compounds in the preferred solvents for the composition.

The resist composition of the invention is preferably applied to a suitable support and contact or projection-exposed imagewise to activating radiation such as light or an electron beam. The "images" that are useful include conventional microimages, such as those useful in forming integrated circuits. Useful supports include sheets and foils of such metals as aluminum, copper, magnesium, zinc, etc.; glass and glass coated with such metals as chromium, chromium alloys, steel, silver, gold, platinum, etc.; synthetic polymeric materials such as poly(alkyl methacrylates), e.g., poly(methyl methacrylate), polyester film base, e.g., poly(ethylene terephthalate), poly(vinyl acetals), polyamides, e.g., nylon, cellulose ester film base, e.g., cellulose nitrate, cellulose acetate, cellulose acetate propionate and cellulose acetate butyrate. For the manufacture of integrated circuit devices, silicon or silicon dioxide wafers, as well as silicon nitride and chromium-coated glass plate supports, are particularly useful. Depending upon the support selected, adhesion aids are optionally applied first as a sub-coating.

Any conventional method can be used to apply the composition to the support. The preferred method is by coating a solution using an appropriate solvent. Useful coating techniques include whirler-coating, spray coating, curtain coating, and roll coating. Useful solvents include alcohols, esters, ethers, and ketones and particularly ethanol, 2-ethoxyethyl acetate, n-butyl acetate, 4-butyrolactone, and mixtures thereof.

The dried thickness of the resist coating depends upon the final use and the etchants that are used, if any. Examples of preferred thicknesses range from between 0.5 micron and 20 micron.

It is preferred to use the pre-bake and post-bake techniques described in U.S. Patent No. 4,141,733 with the resist compositions of the invention.

The equipment used to expose the resist is conventional. The exposure times may vary depending on the desired results and the equipment used. Preferred times are within the range of from 5 seconds to 90 seconds.

Following exposure, the latent image so formed is developed by treating the exposed composition with an appropriate developer. Useful developers include conventional alkaline developers for positive-working resists, for example, those containing sodium hydroxide or phosphate. Developers described in U.S. Patent No. 4,141,733 and European Patent No. 23,758, e.g. quarternary alkanol ammonium hydroxides containing a sulfite stabilizer are particularly useful. It is the time needed for such development, i.e., the rate of development, which is markedly improved by this invention.

Following development, conventional wet or dry etching processes are useful to etch away the support in the areas left unprotected by the development step.

As noted, another advantageous result of the present invention is the maintenance of a photographic speed of the composition that is substantially as high as that described in U.S. Patent No. 3,661,582. Presumably this advantageous result occurs because, except for polyhalogenation, the sensitivity enhancing agent is otherwise the same as the heterocyclic compounds therein described. Furthermore, high temperature resistance is also maintained.

The following examples are included for a further understanding of the invention.

Example 1

A stock composition was prepared as follows:

| | |
|---|---|
| cresol-formaldehyde novolak-type resin obtained under the trade name "Alnoval 429K" from American Hoechst (binder) | 22.6 g |
| quinone diazide sulfonic acid ester of trihydroxybenzophenone (light-sensitive compound) | 4.1 g |
| 2-ethoxyethyl acetate (solvent) | 62.0 g |
| n-butyl acetate (solvent) | 6.2 g |
| mixed xylenes (solvent) | 5.1 g |

To separate 10 g portions of the stock composition there were added separate 2.5 millimole portions of the sensitivity-enhancing agents of Table I. The mixture was applied in each case to a chromium-coated glass support at a thickness of 1.0 μm, and dried by convection heating at 90°C for 30 minutes. The resist was imagewise exposed for 6 sec. to a 200-watt medium pressure mercury arc lamp at a distance of about 15 cm using an apparatus having the trade name Oriel 200-watt Solar Simulator, from Oriel Corp. The latent image was developed using an aqueous alkaline developer maintained at a constant temperature and comprising tetramethylammonium hydroxide available under the trade name "LSI-Type" from Hunt Chemical Co. Table I indicates the development rate, i.e. the time needed to obtain complete removal of resist from the exposed areas.

TABLE I

| Example | Sensitivity-Enhancing Agent | Development Rate (Sec.) | ΔT* (Å) |
|---|---|---|---|
| Control A | none | 38 | 400 |
| Control B | benzotriazole | 18 | 100 |
| Control C | 5-chloro-1H-benzotriazole (compound 8 of U.S. Pat. 3,661,582) | 16.5 | 100 |
| 1 | polychlorobenzotriazole, mixture, average n = 3.0 (Preparation No. 1) | 7.5 | 100 |

* ΔT is the thickness removed in the *un*exposed areas during the development time. These values indicated that the improved development rate of exposed resist did not cause the removal of more of the desired resist from unexposed regions.

Example 1 clearly indicates a marked improvement in the development rate compared to that of any of the controls.

Example 2

Use of Different Developer Composition

The procedure of Example 1 was repeated except that a simlar stock resist composition, obtained under the trade name "AZ—1350J" from Shipley Company, Newton, Mass., was used instead, and that the developer used comprised sodium hydroxide, available under the trade name "AZ Developer" from Shipley Company. Table II indicates the development rates:

TABLE II

| Example | Sensitivity-Enhancing Agent | Development Rate (Sec.) | ΔT* (Å) |
|---|---|---|---|
| Control D | none | 55 | 100—200 |
| Control E | benzotriazole | 33 | 0 |
| Control F | 5-chlorobenzotriazole | 19 | 100—200 |
| 2 | polychlorobenzotriazole (same as Ex. 1) | 11 | 100—200 |

* ΔT has the same meaning as in Table I.

Example 3

Indazole as the Sensitivity-Enhancing Agent

The procedure of Example 2 was repeated, except that the sensitivity-enhancing agent was that set forth in Table III, which also indicates the development rates that occurred.

TABLE III

| Example | Sensitivity-Enhancing Agent | Development Rate (sec.) |
|---|---|---|
| Control G | none | 55 |
| Control H | indazole | 41 |
| 3 | polychloroindazole mixture, n $\simeq$ 3.2 | 20 |

Comparative Example

The procedure of Example 2 was repeated, except that the potential sensitivity-enhancing agent was that set forth in Table IV hereinafter.

TABLE IV

| Comparative Example | Sensitivity-Enhancing Agent | Development Rate (sec.) |
|---|---|---|
| Control I | none | 55 |
| Control L | quinoxaline | 52 |
| 1 | 2,3-dichloroquinoxaline | >120 |

The failure of Comparative Example 1 to give an improved development rate demonstrates the importance of the enhancing agent having a hydrogen atom bonded to at least one of the nitrogen atoms.

**Claims**

1. A positive-working resist composition containing a 1,2-quinone diazide condensation product and a sensitivity-enhancing agent which is a heterocyclic compound having one, two or three rings, the nuclear atoms of which consist of carbon atoms and from 2 to 4 nitrogen atoms, at least one of the nuclear nitrogen atoms being bonded to a hydrogen atom characterized in that said compound has at least two halogen substituents appended from nuclear carbon atoms.

2. A composition as defined in claim 1, wherein said sensitivity-enhancing agent is a polyhalogenated compound selected from the group consisting of benzotriazole; 1,2-naphthotriazole; indazole; and 1,3,4-imidazopyridine.

3. A composition as defined in claim 1, wherein said sensitivity-enhancing agent has the formula

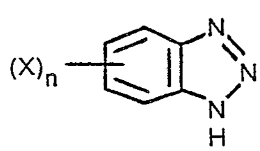

wherein X is halogen and n is a number from 2 to 4.

4. A composition as defined in claim 3, wherein said sensitivity-enhancing agent is a mixture of compounds having n = 2, 3 and 4.

**Patentansprüche**

1. Positiv arbeitende Resist-Zusammensetzung mit einem 1,2-Chinondiazidkondensationsprodukt und einem die Empfindlichkeit steigernden Mittel bestehend aus einer heterocyclischen Verbindung mit ein, zwei, oder drei Ringen, deren Kernatome aus Kohlenstoffatomen und 2 bis 4 Stickstoffatomen bestehen, wobei gilt, daß mindestens ein Kernstickstoffatom an ein Wasserstoffatom gebunden ist, dadurch gekennzeichnet, daß die Verbindung mindestens zwei Halogensubstituenten aufweist, die an Kernkohlenstoffatome gebunden sind.

2. Zusammensetzung nach Anspruch 1, dadurch gekennzeichnet, daß das die Empfindlichkeit steigernde Mittel eine polyhalogenierte Verbindung, ausgewählt aus einem polyhalogenierten Benzotriazol; 1,2-Naphthotriazol; Indazol oder 1,3,4-Imidazopyridin ist.

3. Zusammensetzung nach Anspruch 1, dadurch gekennzeichnet, daß das die Empfindlichkeit steigernde Mittel der folgenden Formel enspricht:

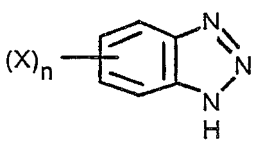

in der X für ein Halogenatom steht und n eine Zahl von 2 bis 4 ist.

4. Zussamensetzung nach Anspruch 3, dadurch gekennzeichnet, daß das die Empfindlichkeit steigernde Mittel aus einer Mischung von Verbindungen der angegebenen Formel mit n = 2, 3 und 4 besteht.

**Revendications**

1. Composition de réserve à effet positif contenant un produit de condensation d'un 1,2-quinone diazide et un agent accroissant la sensibilité qui est un composé hétérocyclique comprenant un, deux ou trois noyaux, les atomes du ou des noyaux étant constitués par des atomes de carbone et de 2 à 4 atomes d'azote, l'un au moins des atomes d'azote du ou des noyaux étant lié à un atome d'hydrogène, composition caractérisée en ce que le dit composé comprend au moins deux substituants halogène fixés sur des atomes de carbone du ou des noyaux.

2. Composition conforme à la revendication 1, dans laquelle le dit agent accroissant la sensibilité est un composé polyhalogéné choisi dans le groupe constitué par le benzotriazole, le 1,2-naphtotriazole, l'indazole et la 1,3,4-imidazopyidine.

3. Composition conforme à la revendication 1, dans laquelle le dit agent accroissant la sensibilité a la formule

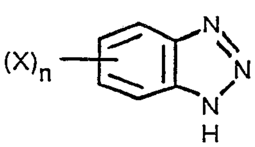

dans laquelle X est un halogène et n est un nombre entier de 2 à 4.

4. Composition conforme à la revendication 3, dans laquelle le dit agent accroissant la sensibilité est un mélange de composés dans lesquels n = 2, 3 et 4.